# EUROPEAN PATENT APPLICATION

(11) **EP 3 608 973 A1**
(43) Date of publication of application: **12.02.2020**
(21) Application number: 18188092.3
(22) Date of filing: 08.08.2018
(51) Int. Cl.: H01L 31/0216, H01L 31/18

(54) **METHOD FOR MANUFACTURING PHOTOVOLTAIC DEVICES AND PHOTOVOLTAIC DEVICES MADE WITH THE METHOD**

(71) Applicant: Meyer Burger Research AG, 2068 Hauterive (CH)
(72) Inventor: Strahm, Benjamin, 1429 Giez (CH)
(74) Representative: Bovard SA Neuchâtel

(57) **Abstract**

The invention relates to a method for manufacturing cristalline photovoltaic devices. The treatment of a semiconductor block (1), preferably made of silicon, is performed through the formation of a functional layer (20) on at least one side wall (10) of said semiconductor block. The functional layer is typically a passivation layer. The method allows separating the side and face treatment of solar cell wafers (100) and allows for example accepting a stronger saw damage etching at wafer side walls, without impacting the final wafer thickness. The invention relates also to a silicon block (1') and a silicon wafer (100') comprising such a functional layer on said one side wall . The invention relates also to the use of such a silicon block or such a silicon wafer, in the manufacturing of solar cells/modules.The invention is also related to a deposition machine comprising a reactor for realizing the functional layer.

## Description

### Technical Field

The invention relates to the field of the manufacturing of photovoltaic devices, such as silicon bricks, blocks of silicon slabs, silicon wafers and solar cells and modules.

More precisely the invention relates to a method to deposit functional layers such as passivation layers on selected areas of silicon bricks and silicon wafers, such as the side areas thereof. The invention relates also to photovoltaic devices comprising functional layers such as passivation layers and a machine configured to realize the deposition of such functional layers on of silicon bricks or blocks comprising silicon slabs.

### Background of the art

Solar cells are the components of solar arrays that use semiconductor materials to convert sunlight directly into electrical power. The most common solar cell material is silicon. The majority of silicon based solar cells on the market, estimated to about 90%, are composed of crystalline silicon, making this the most common type of a solar cell. In such devices, the less defective the material is, the more efficient the material is at converting sunlight into electricity. Monocrystalline solar cells are the most efficient of all and efficiencies higher than 26% have been reported. Monocrystalline cells have also the longest lifetime of all solar cells and many manufacturers offer warranties of up to 25 years on these types of PV systems.

Monocrystalline solar cells are made out of what are called "silicon ingots". In general practice, silicon ingots are separated into silicon bricks which are silicon blocks out of which silicon slices are produced, commonly named silicon wafers. The slices are made in general by sawing techniques. The superiority of monocrystalline solar cells comes with a higher price

More specifically, photovoltaic (PV) or solar cells include a p-type or n-type silicon wafer, or substrate, with an emitter of a n-type or respectively p-type silicon material. The generated voltage and generated current by the PV-cell are dependent on the material properties of the p-n junction, the interfacial properties between the deposited layers, and the surface areas of the device. When exposed to sunlight, the p-n junction of the PV-cell generates pairs of free electrons and holes. An electric field formed across a depletion region of the p-n junction separates the free electrons and holes, providing a voltage. A circuit from the n-side to the p-side allows the flow of electrons when the PV cell is connected to an electrical load. Electrical power is the product of the created voltage times the current generated as the electrons and holes move through the external electrical load and eventually recombine.

The efficiency at which a solar cell converts incident light energy into electrical energy is adversely affected by a number of factors, one of which is the recombination of the charge carriers which may occur in the bulk of the substrate, or on the front and back surface or the side surfaces of a substrate, which is a function of how unterminated chemical bonds, which act as charge carrier trap sites, are situated on the surfaces.

The efficiency of a solar cell may be enhanced by typically using passivation layers on the surfaces of a solar cell. A good passivation layer can provide a considerable reduction of the recombination of electrons and holes in solar cells. Typical passivation layers are Al₂O₃ or SiNₓ layers, formed at the front and/or back surface of solar cells.

All high efficiency solar cells and in particular silicon heterojunction solar cells need perfect passivated silicon surfaces in order to achieve their efficiency potential. Usually a solar cell is considered as a silicon slab with 2 faces and considered as a semi-infinite device. However in practice this is not the case as the perimeter of the solar cell is also a surface, called the side surface or vertical wall of the solar cell.

Up to now, focus in solar development has been put onto the wafers faces of the solar cells and the sides have been largely ignored. This is the reason why today an efficiency gap is observed when measuring solar efficiency on its full area or only at its center. This gap can be as high as 0.5%, which is important in the struggle to get high efficient solar cells wherein only a fraction of a percent in efficiency improvement is significant. The loss is due to imperfect or missing passivation at the wafer side. The reason for this is that during processing, the wafer side is not exposed to the same conditions as the wafer faces and the amorphous silicon deposited at the wafer side, if any, is probably deposited outside of an appropriate process window for good passivation. Current data demonstrate that the recombination rate at the wafer sides of a silicon heterojunction is extremely high, and substantially infinite. The same is very likely the case for a SiNₓ and/or an AlOₓ layer in for example a PERC structure due to plasma perturbation by the PECVD tray carrying the substrates during processing. Same applies for the side passivation of silicon heterojunction solar cells in which amorphous silicon or silicon alloy is used to passivate the wafer surfaces.

Therefore, an additional step has to be performed to eliminate the huge recombination losses at the wafer side. Unfortunately, depositing a passivation layer only at the wafer side without deposition on the wafer faces is an extremely delicate, not very reliable, difficult and expensive operation. Due to the difficulty of side wall passivation of solar cell wafers, this operation step leads to wafer face contamination or to increased cost of manufacturing that annihilate the commercial benefits of this treatment. Additionally, for silicon heterojunction solar cells, any traditional high temperature passivation, for example by using SiNₓ, AlOₓ, SiO₂ cannot be applied after the passivation of the faces of a wafer, since the hetero-contact is destroyed by the high temperature step, typically greater than 220°C, if not ultra-short in time.

An example of the passivation process of a side wall of a solar cell is described in the document US2016023337A1. In this document a low temperature process sequence is described to manufacture a PERC type solar cell. The process comprises the passivation of the edges of a wafer realized at the same time as the front/or backside passivation. One of the problems related to this process is that the process of passivation is the same for all surfaces which is not an ideal solution as the passivation layer for the side walls should be adapted specifically to the surface texture of the side walls which is different than the one of the faces.

On another document CN102263167B the passivation of the edges of a monocrystalline silicon solar cell is described that uses micro-powder (SiO₂, B₂O₃, PBO). With this complex process it is difficult to realize a uniform passivation layer at the edges and there is a great risk of contamination of the wafer surfaces. Also, the stability and so the lifetime of a passivation layer made by using micro-powders is very likely limited.

### Summary of the invention

The present invention proposes to overcome the problem of realizing functional layers, such as passivation layers, locally on the side walls of photovoltaic devices such as semiconductor blocks such as bricks or blocks comprising semiconductor slabs or wafers. The semiconductor blocks are preferably silicon blocks.

The invention proposes a solution which consists of decoupling the treatment of the sides of a solar cell wafer or slab from the processing of that wafer or slab. Said treatment comprises the formation of a functional layer, at the side wall of said blocks. In preferred embodiments said treatment relates to the passivation of the side walls of solar cell wafers.

The invention proposes a solution which avoids to realize functional layers, such as passivation layers, to the sides of wafers used for solar cells, prior to other treatments of the faces of said wafers, such as their passivation. The invention therefor provides a solution so that specific and harsh surface treatments of the sides of a solar cell wafer, such as high temperature treatments, may be applied without destroying, for example, the passivation of the faces of wafers for solar cell applications. More precisely the method allows separating the side and face treatment of solar cell wafers and allows, for example, accepting a stronger saw damage etching at the wafer side than at the wafer face, thus without reducing the final wafer thickness.

The main advantages of the proposed solution with the invention is to enable:
- providing a dedicated treatment so that high quality passivation may be achieved at the wafer sides, leading to a very low recombination rate at every surface of the wafer
- no deposition or contamination of wafer faces, since the treatment is performed at the level of a brick or a bloc comprising a stack ofslab assemblies comprising each a substrate and a wafer;
- realizing a surface treatment of said bricks or blocks which avoids the need to treat the wafers by using masks, back etching and other treatments. This guarantiees high manufacturing throughput;
- providing a simple tool which reduces considerably automation complexity.

More precisely, the invention is achieved by a method for manufacturing cristalline silicon photovoltaic devices, comprising the steps of:
- providing a semiconductor block having a longitudinal axis and at least one side wall, and further comprising the steps of:
- treating said semiconductor block through the formation of a functional layer on at said at least one side wall.

Said semiconductor is preferably made of silicon (Si).

In an embodiment the treatment of the semiconductor block side wall further comprises the steps of:
- removing of any pre-existing damages present on said silicon brick side wall before the deposition of said functional layer;
- cleaning said side wall before the deposition of said functional layer.

In an embodiment said functional layer is a passivation layer.

In an embodiment the formation of said functional layer comprises a chemical vapor deposition step and/or a physical vapor deposition.

In an embodiment the formation of said functional layer comprises the use of a plasma source.

In an embodiment the formation of said functional layer comprises an atomic layer deposition (ALD) process step.

In an embodiment the formation of said functional layer further comprises the immersion of said silicon block in an oxidizing chemical bath comprising an oxidizing substance.

In an embodiment said oxidizing substance is based on a solution made of HNO₃, or H₂O₂ or a water solution comprising dissolved ozone or a combination thereof

In an embodiment the formation of said functional layer further comprises the growth of an oxide layer in a gaseous atmosphere containing oxygen and/or oxygen radicals and/or ozone

In an embodiment the formation of said functional layer provides a surface passivation of said block.

In an embodiment said functional layer comprises a plurality of sub-layers.

In an advantageous embodiment said silicon block comprises a stack of silicon wafers or slabs.

The invention relates also to a silicon block comprising a functional layer on said side walls, said functional layer being manufactured by the method as described.

The invention relates also to a silicon wafer comprising a functional layer on its side wall, said functional layer being manufactured by the method as described.

The invention is also achieved by a deposition machine for realizing a functional layer on the side walls of a silicon block by using the method as described and comprising the following elements:
- a reactor;
- a sample holder and,
- at least one gas source arranged in said reactor.

The invention relates also to the use of silicon devices, such as silicon bricks or silicon blocs or silicon wafers as described, in the manufacturing of solar cells and/or solar modules and their related applications.

### Brief description of the drawings

Further details of the invention will appear more clearly upon reading the following description in reference to the appended figures:
- Figure 1 illustrates a reactor for the surface treatment of silicon blocks;
- Figure 2 illustrates a silicon block comprising a functional layer;
- Figure 3 illustrated a silicon slab having a side wall comprising a functional layer;
- Figure 4 illustrates a silicon slab comprising a functional layer at its side wall and an another functional layer on each of its faces;
- Figure 5 illustrates a semiconductor block consisting of a stack of semiconductor bricks;
- Figure 6 illustrates a semiconductor block consisting of a stack of different shaped semiconductor bricks;
- Figure 7 illustrates a block comprising a plurality of semiconductor slab assemblies, each slab assembly comprising a substrate and a wafer arranged on one of its faces;
- Figure 8 illustrates a block comprising a stack of slab assemblies of Fig.7, arranged to a mechanical frame.
- Figure 9 shows a flow diagram of an embodiment of the method of fabrication.

### Detailed description and embodiments of the invention

The present invention will be described with respect to particular embodiments and with reference to certain drawings but the invention is not limited thereto. The drawings described are only schematic and are non-limiting. In the drawings, the size of some of the elements may be exaggerated and not drawn on scale for illustrative purposes. The dimensions and the relative dimensions do not correspond to actual reductions to the practice of the invention.

It is to be noticed that the term "comprising" in the description and the claims should not be interpreted as being restricted to the means listed thereafter, i.e. it does not exclude other elements.

Reference throughout the specification to "an embodiment" means that a particular feature, structure or characteristic described in relation with the embodiment is included in at least one embodiment of the invention. Thus appearances of the wording "in an embodiment" or, "in a variant", in various places throughout the description are not necessarily all referring to the same embodiment, but several. Furthermore, the particular features, structures or characteristics may be combined in any suitable manner, as would be apparent to a skilled person from this disclosure, in one or more embodiments. Similarly, various features of the invention are sometimes grouped together in a single embodiment, figure or description, for the purpose of making the disclosure easier to read and improving the understanding of one or more of the various inventive aspects. Furthermore, while some embodiments described hereafter include some but not other features included in other embodiments, combinations of features if different embodiments are meant to be within the scope of the invention, and from different embodiments. For example, any of the claimed embodiments can be used in any combination. It is also understood that the invention may be practiced without some of the numerous specific details set forth. In other instances, not all structures are shown in detail in order not to obscure an understanding of the description and/or the figures.

In the following, the present invention will be described in detail with specific reference to the treatment of the side surface 10 of a semiconductor block 1 that may be a continuous block 1 or a block 1 comprising a stack 3 of semiconductor slab assemblies SW as further described. Preferably, the semiconductor material is silicon (Si) and comprises preferably at least 90% of silicon. In embodiments the semiconductor material may comprise or be made of Ge. Said semiconductor material may be a semiconductor compound.

The invention is achieved by a reactor 30 to form at least one functional layer 20 onto a semiconductor block 1 and also by devices such as a semiconductor block 1' or a semiconductor brick 1' or semiconductor wafers 100' that comprise at least a functional layer 20, 20a on their side wall 10, 101, as further described. Preferably the semiconductor material is silicon (Si).

The invention is also achieved by a method to realize said functional layers 20 and is described further in detail.

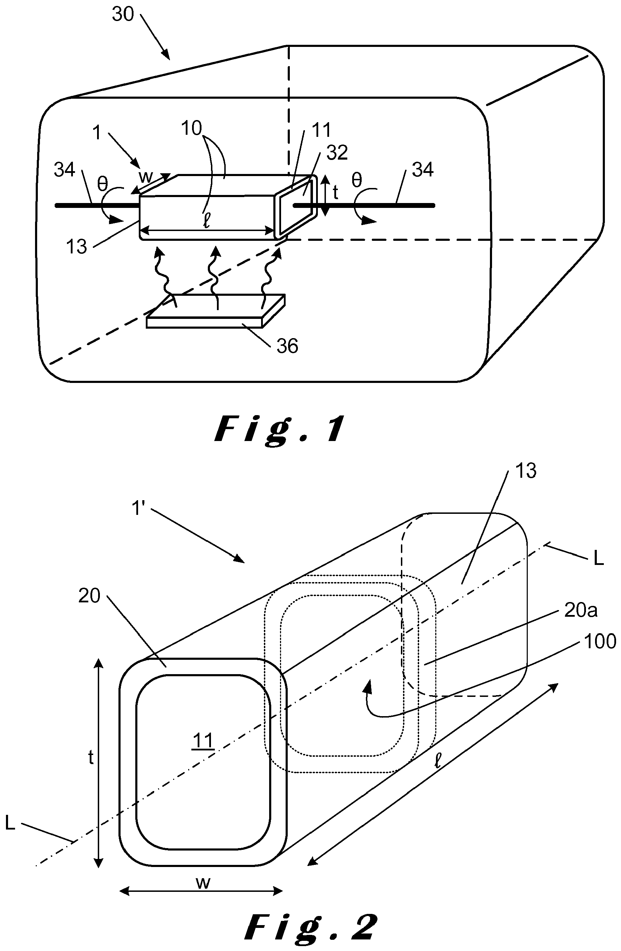

Fig. 1 illustrates an embodiment of a reactor 30 of the invention with which a functional layer 20, described further, may be realized on the side wall 10 of a block 1 of semiconductor material. Said block 1 may be a continuous semiconductor block such as a silicon ingot or may be a portion of a silicon ingot, said portion being defined as a brick. Said block 1 may also be a single slab assembly or a stack of slab assemblies SW as further described in embodiments.

### Semiconductor block 1

The invention is illustrated in the embodiment of Fig.1. A semiconductor block 1, preferably made of silicon, is preferably positioned on a block holder 32 fixed to a rotation axis 34 which is part of the reactor 30. At least one source 36 is arranged in the reactor 30 and provides gases of which at least a portion is deposited to the side walls 10 of said block 1. The block 1 may have a square or rectangular cross section, defined perpendicular to its longitudinal axis L. A block 1 according to the invention may have any dimension and have the following preferred dimensions:
- a length I, defined parallel to said axis L, between 10mm and 1000mm;
- a width w between 50mm and 300mm;
- a thickness t between 50mm and 300mm.

In variants, a block 1 is a continuous brick and may have a cylindrical shaped cross section, in which case it has only one cylindrical shaped side wall 10.

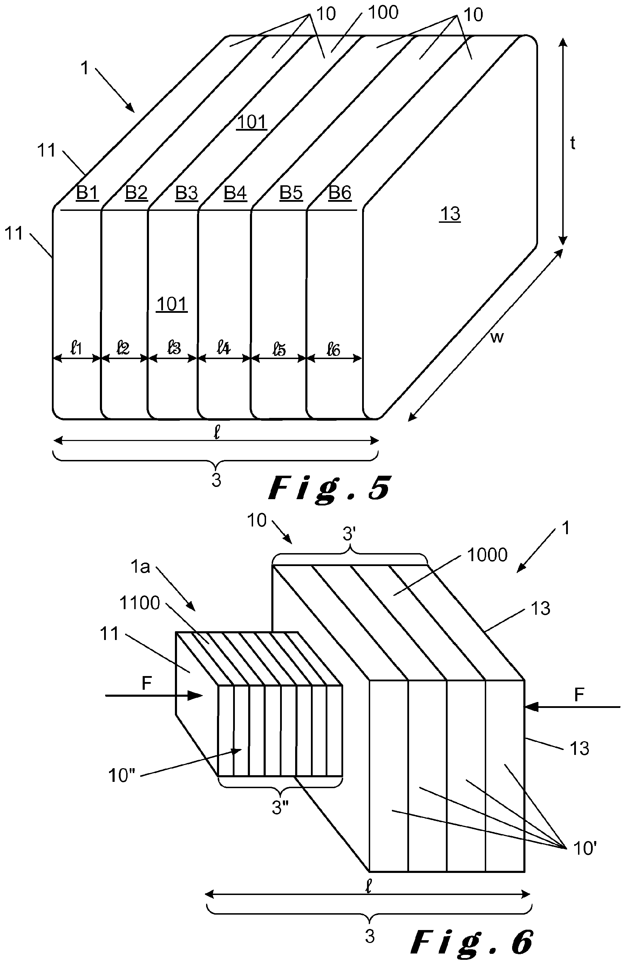

In an advantageous embodiment said block 1 is made of a stack 3 of silicon bricks B1-B6 as illustrated in Fig. 5 and each brick B1-B6 of said stack 3 may have any dimension and have the following preferred dimensions:
- a length 11-16, defined parallel to said axis L, between 10mm and 300mm;
- a width w between 50mm and300;
- a thickness t between 50mm and 300mm.

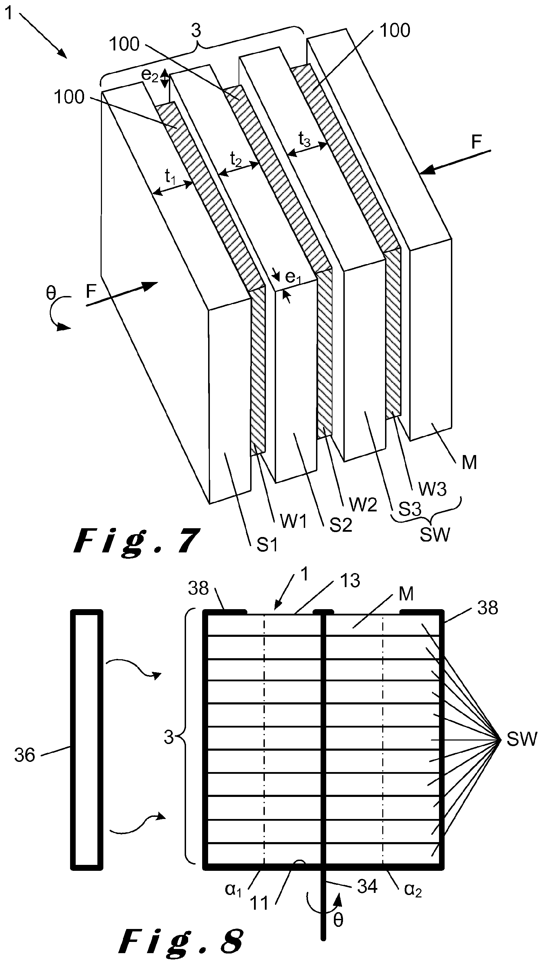

In an advantageous variant, illustrated in Fig. 7, said block 1 may comprise a plurality of slab assemblies SW, each assembly SW comprising a slab S1-S3, used as a substrate, and at least one wafer W1-W3 wafer fixed on one of the faces of said substrates S1-S3. Slabs S, S1-S3 are defined broadly herein as semiconductor plates and may have any shape or dimensions. The purpose of the use of slabs S, S1-S3 as substrates, in said advantageous variant, is to provide means to fix a wafer W1-W3 that may be separated and individualized form said slabs S, S1-S3 after the deposition process of the functional layer 20 on the side of said block 1. Said slabs S, S1-S3 must not necessarily have the shape of a flat plate but may be a structured plate and may comprise apertures at least partially across their thickness t1-t3. It is understood that there is no limit to the number of slab assemblies SW comprising wafers W1-W3 in said stack 3. In examples, a stack 3 may comprise more than 10 slab assemblies SW. In an embodiment a block 1 may consist of a single slab assembly SW

Wafers W are defined here as thin single silicon plates having a thickness of less than 800µm and preferably greater than 100µm. A slab S as defined before may have any thickness t1-t3, for example a thickness between 800µm and 30mm, preferably between 2 mm and 300mm. It is understood here that a slab S, being a substrate, is usually thicker than said wafers W and may comprise several, not necessarily identical, layers. As illustrated in Fig.7, wafers W1, W2, W3 arranged in said slab assemblies SW may be different type of wafers and have different dimensions. The wafers W1-W3 fixed on said slabs S in said slab assemblies SW, in the variant of Fig. 7, may have the same or smaller lateral dimensions w, t than the lateral dimensions of their respective slabs S1, S2, S3. In the variant of Fig.7 said wafers W1, W2, W3 may be fixed to said slabs S1, S2, S3 by gluing or by any other technique such as the use of an epitaxial technique. Said slabs S1, S2, S3 and/or said wafers W1, W2, W3 are preferably made of silicon but may be made of different materials. In variants a single slab assembly SW may comprise more than 1 wafer fixed to the slab S of said slab assembly SW, for example by epitaxial techniques.

In variants, said block 1 may comprise a plurality of slab assemblies SW, as described before, that are separated by spacers. A block 1 comprising a plurality of slab assemblies SW as defined before, is preferably arranged, during the operation of the reactor 30, in a mechanical system which comprises, preferably, means to exercise a lateral force F as illustrated in Figs. 6 and 7. In variants of the embodiment of Fig.7 the individual slab assemblies SW, as described before, may be kept in contact during the deposition process by using a variety of methods such as gluing or epitaxial methods or other methods for example using Vanderwaals forces. Fig. 8 illustrates an example of said mechanical system 38.

In variants, said stack 3 may comprises at least two stacks 3', 3", each stack 3, 3' may comprise different types of bricks or slab assemblies SW that may be made of different materials and have different shapes and/or thicknesses such as illustrated in the variant of Fig. 6. Piling at least two different stacks 3, 3' together during the process may be useful, for example to enhance the production output of the functional layer deposition process.

### Functional layer

In a preferred advantageous embodiment, said functional layer 20 is a passivation layer. Passivation layers of solar cells are well known and are for example described in: ABERLE, Armin. (2000). Crystalline silicon surface passivation: a review. Progress in Photovoltaics: Research and Applications. 8; DOI: 10.1002/1099-159X(200009/10)8:5<473::AID-PIP337>3.0.CO;2-D.

Realizing passivation layers is known to the skilled person and is not detailed further here. Realizing a passivation layer on the side wall 10 of a semiconductor block 1, such as a silicon block 1, allows to provide semiconductor bricks 1' or wafers 100' that comprise a passivation layer 20, 20a on their side walls 10, 101, 100b prior to the deposition of further layers on at least one of the faces 102 of individual wafers 100'. This allows providing, in a subsequent second step, the realization of further layers, such as further passivation layers, on at least one of the faces 102, 104 of wafers to be used in the manufacturing of solar cells.

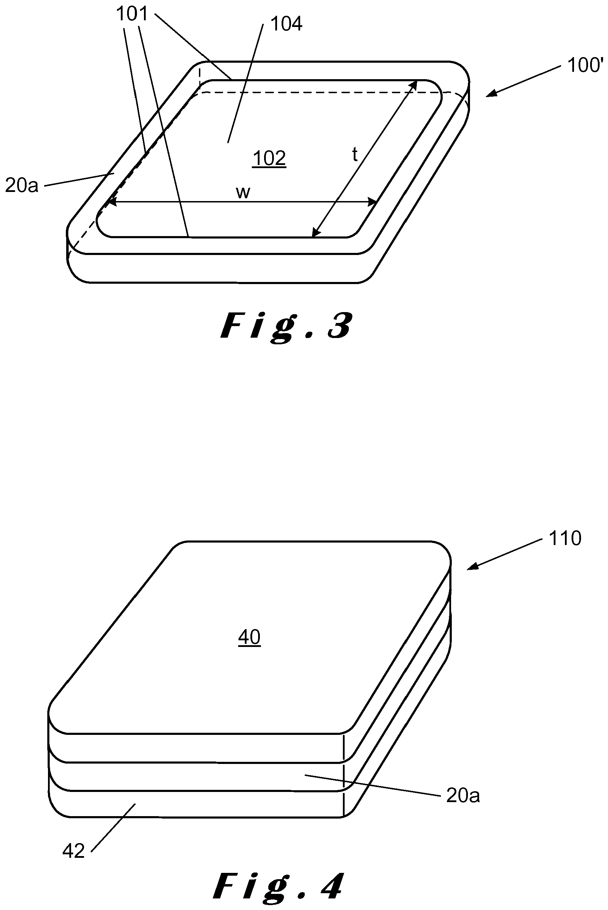

Fig. 3 shows schematically a cross section of a semiconductor wafer 100' that has been realized out of a block 1' comprising a functional layer 20 according to embodiments of the invention. Individual wafers 100' may be realized from said treated block 1' by for example sawing techniques or other wafer 100' separation techniques such as laser cutting techniques or by using a chemical process or a combination of such separation techniques.

In a preferred embodiment, said functional layer 20 is a passivation layer made of a material chosen among SiₓN_{y}, SiO₂, AlOₓ, Si:H, SiC:H or a combination of these materials. It is understood that a passivation layer 20 of the side 10 of said blocks 1 or bricks or wafers 100 may be made by other materials which reduce recombination rates in solar cells. Said passivation layer 20 may comprise at least one additional layer which improves the properties of said passivation layer, such as the surface hardness of the side passivation layers 20, 20a. For example a thin layer of nanocrystalline diamond may be applied on at least a portion of said side passivation layer 20, 20a, improving for example the handling resistance of solar cell wafers 100.

In variants, the functional layer 20 of the invention may have another function than a passivation function.

In embodiments, the functional layer 20 may be:
- an electrical isolation layer;
- a mechanical protection layer;
- a layer giving resistivity against chemical attack (i.e. acidic or alkaline etching)
- an electrical passivation of the surface;
- a combination of the mentioned features;

Fig. 4 shows schematically a cross section of a wafer 100', according to an embodiment of the invention wherein said wafer 100' comprises a functional layer 20 on its side wall 101 and at least a second functional layer 40, 42 on at least one of its faces. Said at least a second functional layer 40, 42 may be different than the functional layer 20 realized on the wafers side wall 101. In a preferred embodiment said at least a second functional layer 40, 42 is also a passivation layer. It is also understood that, in variants, at least one of said second layers 40, 42 may overlap at least partially the functional layer 20a on the side walls, as illustrated in Fig.4.

It is understood that said functional layer 20 may have a thickness that is not uniform. More precisely, the thickness of a functional layer 20 realized on said block 1, brick, or wafer 100 may not be uniform and vary along the circumference of such devices. In variants, said functional layers 20, 20a may comprise gaps or local depressions or local projections. This may be the case resulting from layer deposition configurations such as the one illustrated in Fig.10 wherein a block 1, comprising a plurality of slab assemblies SW, is arranged in a mechanical frame comprising side springs or clips.

In variants, functional layers 20, 20a may comprise at least two portions comprising different functional layers. For example , said functional layer 20, 20a may have a first type of function layer on less than 50% of the circumference of said block 1 and/or slab 100 and a second type of functional layer on the remaining portion of said circumference.

In embodiments said functional layer 20 realized on the side walls of said blocks, slabs or wafers may be a multilayer.

For example, the multilayer may be a silicon oxide layer in combination with a silicon nitride layer, an hydrogenated silicon layer capped with a dielectric layer such as aluminum oxide or silicon nitride or both, an hydrogenated silicon layer with a silicon carbide layer.

### Deposition machine

The invention is also achieved by machine to realize the described functional layers 20, such as a passivation layer. The reactor 30, illustrated in Fig.1, is configured to realize a functional layer 20 to the side walls 10 as described before, and comprises at least the following elements:
- a reactor 30;
- a sample holder 32, and
- at least one gas source 36 arranged in said reactor 30.

In embodiments said reactor 30 may comprise a plurality of axes configured to fix each a block 1 of semiconductor material. In variants different blocks 1 may be processed at the same time, for example a first block may be made of one type of silicon and a second block may be made of another type of silicon, for example a partially doped silicon block.

In a preferred embodiment, a functional layer 20 may be deposited by rotating said block 1 in front of a gas and/or plasma source. In other variants, said blocks 1 may be processed by translating them, along said longitudinal axis L, in front of a plurality of gas sources 36. In variants said reactor 30 may comprise a combination of translation and rotation and/or oscillation movements to achieve the realization of a functional layer 20.

It is understood that said reactor may 30 comprise additional processing means, such as etching means or further deposition means of further layers, said additional processing means may be executed before, during or after the formation of said functional layer 20 or its sublayers. A typical processing speed is to realize the formation of the functional layer 20 on at least 2 bricks in one hour.

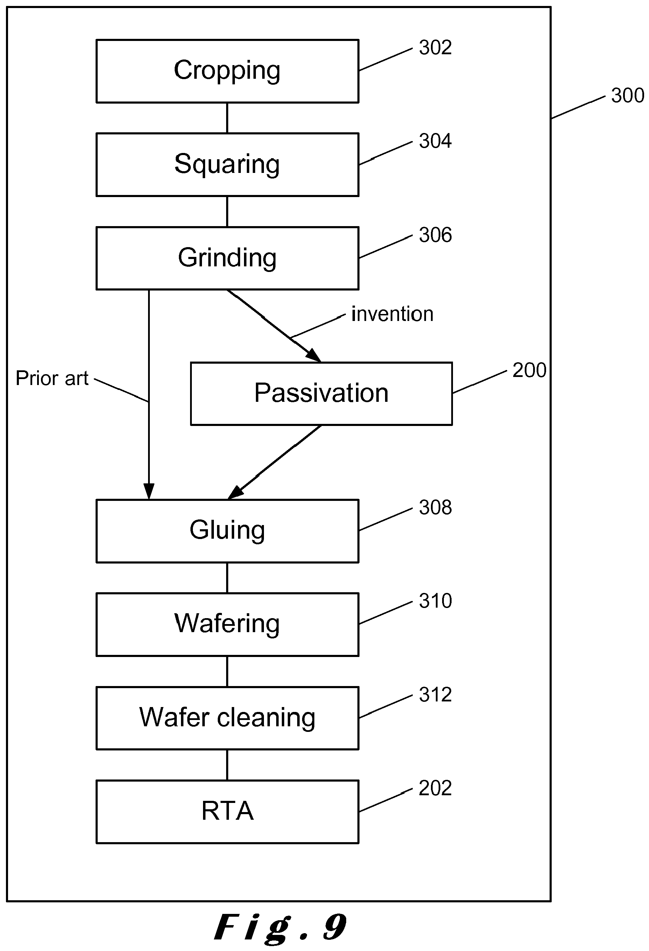

The reactor 30 of the invention may comprise means to fix a block 1 comprising a plurality of slab assemblies SW as illustrated in Fig. 9. An exemplary block 1 of the embodiment of Fig. 9 comprises a dummy substrate or mechanical element M so that means provided in said reactor may exercise a lateral force F to said block and keep the stack of slab assemblies SW in contact during the realization of the functional layer 20. Such means may comprise for example a mechanical spring or clip system 38 as illustrated in Fig. 9 which shows a reactor 30 configuration in which a block 1, comprising a stack 3 of wafers 100 and/or slabs, is fixed to a single vertical rotation axis 34, substantially parallel to the direction of gravity.

It is understood that in embodiments wherein slab assemblies SW of a block 1 are held together by a lateral mechanical system, as illustrated in Fig.9, small portions of said side wall may 10 not be covered by said functional layer after the deposition process. This may be solved by performing the side wall treatment in at least two steps, comprising the positioning of said block 1 according to at least two different angular positions α1, α2, as illustrated in Fig. 9.

It is also understood that the reactor 30 may comprise several rotation axes and several block holders so that several blocks may be treated in parallel.

### Method of fabrication

The invention is also achieved by a method for manufacturing cristalline silicon photovoltaic devices, and comprising the steps of:
- providing a silicon block 1 having a longitudinal axis L and at least one side wall 10,
- treating said silicon block 1 through the formation of a functional layer 20 at said at least one side wall 10.

In embodiments the method comprises the further steps of:
- removing of any pre-existing damages present on said silicon brick side wall 10 before the formation of said layer 20;
- cleaning said side wall 10 before the formation of said layer 20.
In an embodiment the formation of said functional layer 20 is realized by rotating said block around an axis. In a variant said block may be oscillated by an angle θ that may be at least 180°. In an embodiment the formation of said functional layer 20 is realized by translating said block parallel to its longitudinal axis.

In an embodiment the formation of said functional layer 20 comprises a chemical vapor deposition step and/or physical vapor deposition step.

In an embodiment, the formation of said functional layer 20 comprises the use of a plasma source.

In an embodiment the formation of said functional layer 20 comprises an atomic layer deposition (ALD) process.

In an embodiment the formation of said functional layer 20 further comprises the immersion of said silicon block 1 in an oxidizing chemical bath comprising an oxidizing substance.

In an embodiment said oxidizing substance is based on a solution made of HNO₃, or H₂O₂ or a water solution comprising dissolved ozone.

In an embodiment, the formation of said functional layer 20 further comprises the growth of an oxide layer in a gaseous atmosphere containing oxygen, oxygen radicals or ozone, or a combination of them.

In an embodiment the formation of said functional layer 20 provides a surface passivation of said block 1. In an advantageous embodiment, a passivation of the side walls 10 of a silicon block 1 may be performed after the squaring of a brick 1, or a block comprising a plurality of slab assemblies SW, and may comprise, besides standard processing steps, the following additional steps 200, 202:
- the removal of squaring damages by KOH etching;
- cleaning after removal of squaring damages by using HCL, Ozone (O₃) and HF;
- deposition of a passivating layer, preferably at low temperature to avoid long brick 1 heating and cooling;
- optionally rapid thermal annealing (RTA) of wafers 100' after wafer cutting and cleaning to activate the passivation layers 20a.

Fig. 9 illustrates a process flow 300 of a typical deposition process 200 of a passivation layer 20 according to the invention. In the exemplary process flow of Fig.9, the passivation step 200 of the invention is executed between the grinding step 306 and the gluing step 308 of a standard process flow comprising the following standard steps 302, 304, 306,308, 310, 312:
- providing a semiconductor block 1;
- cropping 302 of said block 1 ;
- squaring 304 of said block 1;
- grinding 306 of said block 1 ;
- gluing 308 of said block 1;
- wafering 310 of the block 1 , consisting of realizing individual wafers 100';
- wafer cleaning 312.

The standard steps 302, 304, 306,308, 310, 312, are well known to the skilled person and are not detailed further herein.

In an embodiment, the method comprises steps that provide the realization of a functional layer 20 comprising a plurality of sub-layers as described above.

In an advantageous embodiment, a silicon block 1 may comprise a stack of silicon slabs or wafers as described above and of which an example is illustrated in Fig.6. In such an embodiment, said block 1 is individualized in silicon wafers 100 for further processing after the deposition of the functional layer 20. In variants said block 1 may comprise a plurality of portions that may be separated in a plurality of individual blocks comprising a function layer and so that these individual blocks may undergo different subsequent mechanical or chemical treatments.

The invention is also achieved by a silicon block 1' comprising a functional layer, such as a passivated side wall 101 realized by the method of the invention.

The invention is also achieved by a silicon wafer 100' comprising a functional layer, such as a passivated side wall 24 realized by the method of the invention.

The invention relates also to the use of semiconductor devices such as silicon blocks or bricks or wafers or slab assemblies SW, as described above, in the manufacturing of solar cells and/or solar modules.

## Claims

1. Method for manufacturing cristalline semiconductor photovoltaic devices, comprising the step of:
- providing a semiconductor block (1) having a longitudinal axis (L) and at least one side wall (10),
**characterized in that** it further comprises a step of:
- treating said semiconductor block (1) through the formation of a functional layer (20) on at said at least one side wall (10).

2. The method according claim 1, **characterized in that** the treatment of the semiconductor block side wall (10) further comprises the steps of:
- removing of any pre-existing damages present on said semiconductor brick side wall (10) before the deposition of said functional layer (20);
- cleaning said side wall (10) before the deposition of said functional layer (20).

3. The method according to claim 1 or claim 2, **characterized in that** said functional layer (20) is a passivation layer.

4. The method according to any one of claims 1 to 3, **characterized in that** the formation of said functional layer (20) comprises a vapor deposition step.

5. The method according to any one of claims 1 to 4, **characterized in that** the formation of said functional layer (20) comprises the use of a plasma source.

6. The method according to any of claims 1 to 5 **characterized in that** the formation of said functional layer (20) comprises an atomic layer deposition (ALD) process step.

7. The method according to any one of claims 1 to 6, **characterized in that** the formation of said functional layer (20) further comprises the immersion of said semiconductor block (1) in an oxidizing chemical bath comprising an oxidizing substance.

8. The method according to any one of claims 1 to 7, **characterized in that** said oxidizing substance is based on a solution made of HNO₃, or H₂O₂ or a water solution comprising dissolved ozone.

9. The method according to any one of claims 1 to 8, **characterized in that** the formation of said functional layer (20) further comprises the growth of an oxide layer in a gaseous atmosphere containing oxygen,and/or oxygen radicals and/or ozone.

10. The method according to any one of claims 1 to 9, **characterized in that** said functional layer (20) comprises a plurality of sub-layers.

11. The method of any one of claims 1 to 10, **characterized in that** it comprises an additional step of realizing a plurality of single silicon wafers (100) out of said block (1), after said formation of a functional layer (20) on said block (1).

12. A silicon block (1') comprising a functional layer (20) on said at least one side wall (10), said functional layer (20) being manufactured by the method according to any one of claims 1 to 11.

13. A silicon wafer (100') comprising a functional layer (20a) on at least one of its side walls (101), said functional layer (20) being manufactured by the method according to any one of claims 1 to 11.

14. A deposition machine for realizing a functional layer (20) on the side walls (10) of a silicon block (1) by using the method according any one of claims 1 to 11 and comprising the following elements:
- a reactor (30);
- a block holder (32), and
- at least one gas source (36) arranged in said reactor (30).

15. Use of a silicon block (1') or a silicon wafer (100') according to claim 12 or claim 13 in the manufacturing of solar cells and/or solar modules.
